# DEMANDE DE BREVET EUROPEEN

(11) **EP 0 945 940 A1**
(43) Date de publication de la demande: **29.09.1999**
(21) Numéro de dépôt: 99400450.5
(22) Date de dépôt: 24.02.1999
(51) Int. Cl.: H02B 1/04, H01H 71/08, H01H 71/02

(54) **Ensemble de départ-moteur**

(30) Priorité: 27.03.1998 FR 9803944
(71) Demandeur: Schneider Electric Industries SA, 92100 Boulogne Billancourt (FR)
(72) Inventeur: Girard, Michel, 21910 Corcelles-les-Citeaux (FR)

(57) **Abrégé**

Ensemble de départ-moteur comprenant des éléments de départ assemblés côte à côte sur au moins un socle (S), chaque élément comportant des appareils interrupteurs(1, 3, 40) raccordés à des connecteurs respectifs (50, 51, 52) d'un circuit imprimé logé dans le socle, lesdits connecteurs étant reliés à un connecteur amont (6) du circuit doté de groupes de broches de connexion (D1-D8, C1-C8, R1-R8). Le connecteur amont (6) comprend des broches utilisées pour les appareils du socle (S) raccordées selon un ordre des broches correspondant à celui des emplacements des éléments sur le socle , et
des broches utilisables pour les appareils d'au moins un socle (S) voisin. Le circuit imprimé (C) comporte un connecteur aval (7) à groupes de broches de connexion identiques à ceux du connecteur amont (6), les broches utilisables du connecteur amont (6) étant reliées, en nombre égal et dans l'ordre, aux premières broches de connexion du connecteur aval (7).

## Description

La présente invention concerne un ensemble de départ-moteur comprenant des éléments de départ assemblés côte à côte et fixés sur au moins un socle de support, chaque élément comportant des appareils électriques interrupteurs constitués par un disjoncteur, un contacteur et un organe interrupteur de commande de la bobine du contacteur, le socle logeant un circuit imprimé muni de pistes conductrices et d'un connecteur doté de groupes de broches de connexion auxquelles sont reliés, via les pistes conductrices, les appareils interrupteurs, et qui sont destinées à être reliées à un ou plusieurs conducteurs d'un système de contrôle et de commande de l'ensemble.

Chaque élément de départ sert à alimenter une charge telle qu'un moteur, pour le mettre en marche ou à l'arrêt en fonction de la mise sous tension ou hors tension de conducteurs de contrôle du contacteur; le disjoncteur est adjoint au contacteur pour couper les lignes d'alimentation du contacteur lorsqu'il constate au moyen d'organes de surveillance appropriés une anomalie de fonctionnement, par exemple une surintensité, dans l'une au moins de ces lignes.

La configuration d'un tel ensemble de départ-moteur simplifie les opérations de câblage et facilite le raccordement des éléments à un système de contrôle et de commande tel qu'un automate ou à un bus de terrain.

Le nombre d'éléments de départ sur un socle étant limité, l'utilisateur peut être amené à vouloir rajouter d'autres éléments de départ; c'est pourquoi il est souvent nécessaire d'associer plusieurs socles côte à côte pour obtenir le nombre souhaité d'éléments.

De manière à faciliter et surtout à rendre rapide la mise en place des socles, il est nécessaire de pouvoir les juxtaposer dans un ordre quelconque, en étant assuré que le connecteur amont du socle amont réalise correctement la liaison de l'ensemble des éléments des différents socles avec l'appareil de contrôle et de commande.

Dans ce but, l'ensemble de départ-moteur de l'invention est caractérisé en ce que le connecteur amont comprend des broches utilisées pour les appareils du socle et des broches utilisables pour les appareils d'au moins un socle voisin, que les appareils interrupteurs des divers éléments de départ d'un socle sont raccordés à des broches de connexion du connecteur amont selon un ordre des broches correspondant à celui des emplacements des éléments sur le socle, et que le circuit imprimé comporte un connecteur aval à groupes de broches de connexion identiques à ceux du connecteur amont, les broches utilisables du connecteur amont étant reliées, via des secondes pistes conductrices, en nombre égal et dans l'ordre, aux premières broches de connexion du connecteur aval.

La description va maintenant être décrite avec plus de détails en regard des dessins annexés, parmi lesquels :
- la figure 1 représente en perspective un ensemble de départ-moteur conforme à l'invention;
- la figure 2 montre en perspective le circuit imprimé du socle ;
- la figure 3 illustre le schéma électrique d'un élément de départ;
- les figures 4 et 5 sont les schémas de raccordement électrique entre plusieurs socles selon deux exemples respectifs ;
- la figure 6 montre le schéma d'un socle doté d'un appareil contacteur-inverseur.

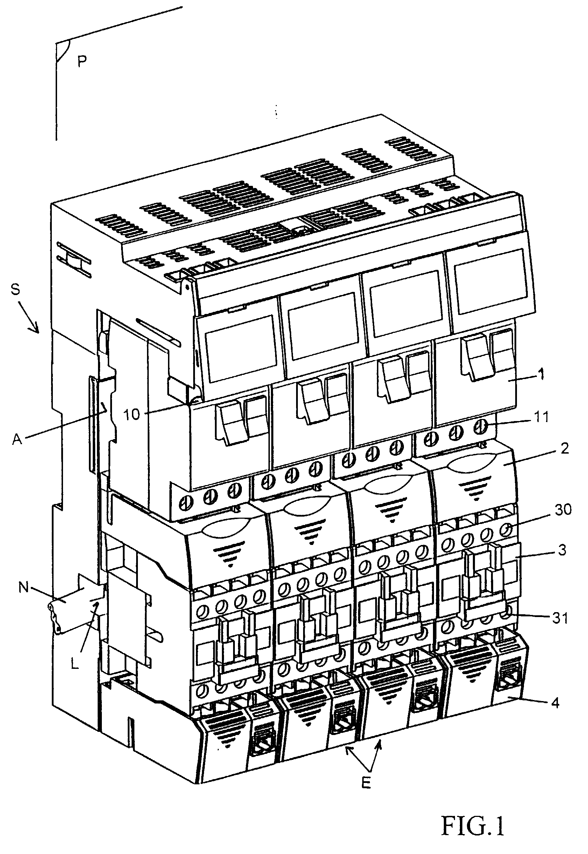

Le dispositif illustré à la figure 1 est constitué d'un socle S sur lequel sont emboîtés et connectés les éléments de départ-moteur E. Un socle peut être configuré pour comporter un, deux, ou quatre éléments E au plus. Il est possible d'assembler et de connecter plusieurs socles entre eux pour constituer un ensemble de départ-moteur de huit éléments au plus.

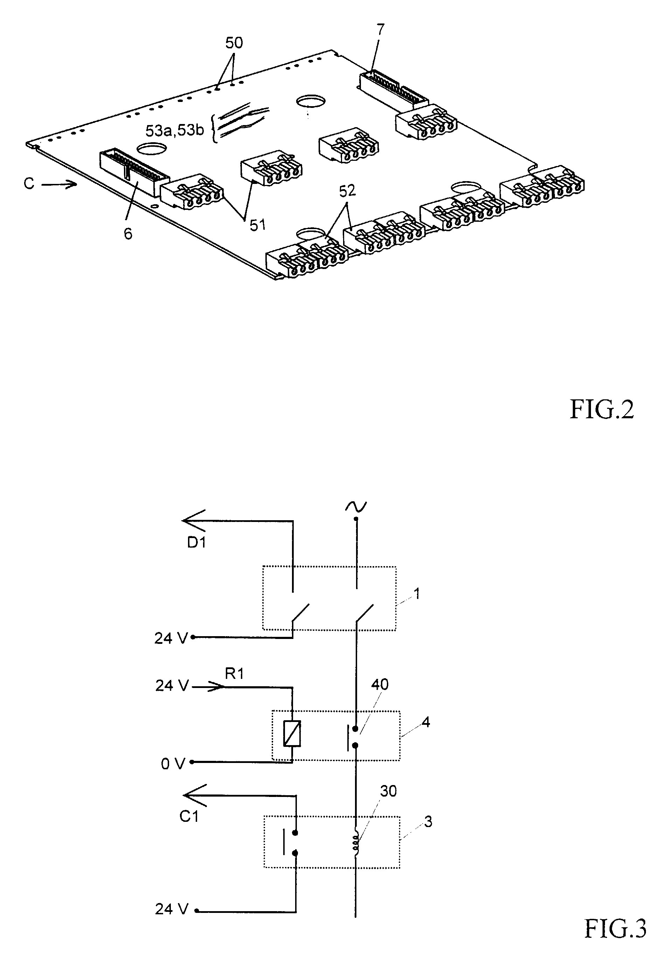

Le socle S comporte un corps de faible profondeur doté d'une aire frontale A parallèle à un plan P pour porter les éléments E. Il loge un circuit imprimé C (figure 2) qui est parallèle à P et assure les interconnexions de commande des éléments E et la connexion externe de commande et de contrôle des éléments E avec un bus ou un système tel que par exemple un automate programmable non illustré.

Le socle S peut être fixé à l'arrière à un support par des moyens de fixation usuels : éléments d'encliquetage, vis, etc... L'assemblage mécanique de plusieurs socles S entre eux est réalisé latéralement, de préférence, par des moyens d'encliquetage non illustrés sur les figures.

Un élément E de départ est constitué par un disjoncteur 1, un bloc intermédiaire 2 et un contacteur 3 et un bloc inférieur 4.

Le disjoncteur 1 comprend des bornes amont 10 de puissance destinées à recevoir des éléments conducteurs reliées à des barres d'alimentation, et des bornes aval 11 devant être connectées aux bornes de puissance du contacteur. Le bloc intermédiaire 2 sert au raccordement électrique des bornes aval 11 du disjoncteur 1 à des bornes amont de puissance 30 du contacteur 3. Le contacteur 3 présente des bornes aval 31 de puissance destinées à être reliées à une charge non représentée telle qu'un moteur. Enfin, le bloc inférieur 4 comprend un organe interrupteur 40 servant à commander la bobine 30 du contacteur, tel qu'un relais mécanique ou statique (figure 3).

Les appareils électriques interrupteurs 1, 3 et 40 sont connectés au circuit imprimé C via des connecteurs respectifs 50, 51, 52. Le circuit imprimé C comprend d'une part un connecteur amont 6 assurant la connexion de ces appareils avec l'automate programmable pour leur contrôle et leur commande, et d'autre part un connecteur aval 7 assurant l'interconnexion avec le connecteur 6 du socle suivant. Les termes amont et aval qualifient la proximité du connecteur vis à vis du système de contrôle et de commande. Des pistes 53a, 53b du circuit imprimé réalisent les interconnexions souhaitées d'une part entre les connecteurs 50-52 et le connecteur amont 6, et d'autre part entre le connecteur amont 6 et le connecteur aval 7.

Le socle S comprend un logement latéral L pour accueillir une nappe N de conducteurs de contrôle et de commande qui est destinée à être connectée au connecteur amont 6 pour assurer la liaison avec le bus ou l'automate programmable.

Le connecteur amont 6, de type HE10, est doté de trente broches de connexion qui sont réparties en seize broches d'entrée destinées à délivrer des informations de contrôle à l'automate, huit broches de sortie destinées à recevoir des ordres de commande de l'automate, et les broches restantes étant dédiées à l'alimentation en 24 Volts des appareils électriques.

Les seize broches d'entrée sont partagées en deux groupes de huit entrées, à savoir huit entrées D1-D8 qui correspondent à l'état ouvert ou fermé des huit disjoncteurs potentiels de plusieurs ensembles de départ-moteur associés, et huit autres entrées C1-C8 qui correspondent à l'état ouvert ou fermé des huit contacteurs potentiels couplés aux disjoncteurs. Le groupe des huit broches de sortie R1-R8 correspond à l'état ouvert ou fermé des huit relais potentiels commandant l'alimentation des huit bobines associées respectivement aux contacteurs.

Les pistes conductrices 53a du circuit imprimé sont d'une part reliées aux connecteurs 50, 51, 52 des appareils 1, 3 et 40 constituant chaque élément E, et sont d'autre part reliées, selon un ordre numérique correspondant à celui des emplacements des éléments sur le socle, aux premières broches d'entrée D1, Ci et suivantes et aux premières broches de sortie R1 et suivantes du connecteur amont.

En fonction de la capacité du socle S, c'est-à-dire du nombre d'éléments de départ E qu'il peut recevoir, un nombre correspondant de broches de son connecteur amont seront utilisées. Ainsi, pour un socle à quatre éléments, seules au plus quatre broches D1-D4, quatre broches C1-C4 et quatre broches R1-R4 sont utilisées. Les autres broches d'entrée et de sortie, dénommées par la suite "broches utilisables", sont gérées d'une manière qui sera expliquée ci-après.

Le connecteur aval 7 est aussi de type HE10 et présente des groupes de broches de connexion identiques à ceux du connecteur amont. Les broches de connexion d'entrée et de sortie utilisables du connecteur amont 6 sont reliées, via les secondes pistes conductrices 53b, en nombre égal et dans l'ordre numérique, aux premières broches de connexion d'entrée et de sortie du connecteur aval 7. Cette configuration de raccordement permet d'associer plusieurs socles dans un ordre indifférent, le connecteur amont du socle placé en amont réalisant toujours l'adressage à l'automate de l'ensemble des éléments des divers socles. La liaison électrique de deux socles est réalisée par le raccordement du connecteur aval 7 du premier socle au connecteur amont du socle suivant dans le même ordre numérique des broches.

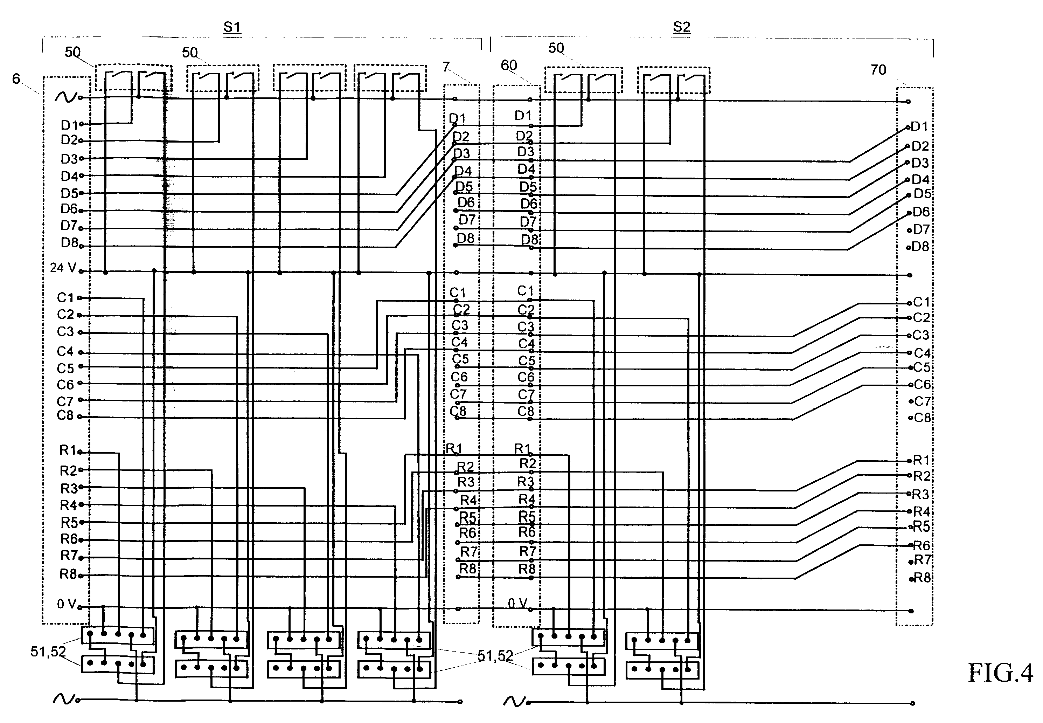

L'exemple de la figure 4 montre l'association d'un socle Si doté de quatre éléments et d'un socle S2 doté de deux éléments, le socle Si étant placé en amont du socle S2.

Les appareils de chacun des quatre éléments du socle Si sont respectivement connectés aux premières broches D1-D4, C1-C4 et R1-R4 du connecteur amont 6. Les broches utilisables D5-D8, C5-C8 et R5-R8 du connecteur amont sont reliées aux premières broches D1-D4, C1-C4 et R1-R4 du connecteur aval 7.

Les appareils de chacun des deux éléments du socle S2 sont respectivement connectés aux premières broches D1-D2, C1-C2 et R1-R2 du connecteur amont 60. Les broches utilisables D3-D8, C3-C8 et R3-R8 du connecteur amont 60 sont reliées aux premières broches D1-D6, C1-C6 et R1-R6 du connecteur aval 70.

Le conducteur reliant le connecteur amont 60 du socle S2 au connecteur aval 7 du socle Si raccorde entre elles les broches de même numérotation.

De cette manière, les broches D1-D2, C1-C2 et R1-R2 du connecteur amont 60 du socle S2 sont reliées aux bornes utilisables D5-D6, C5-C6 et R5-R6 du connecteur amont 6 du socle S1, raccordé lui-même à l'automate.

Si l'utilisateur avait choisi de disposer le socle S2 en amont du socle S1. Le connecteur amont 60 du socle S2 assurant la liaison avec l'automate présenterait ses broches de connexion D1-D2, C1-C2, et R1-R2 raccordés aux appareils des deux éléments de son socle, et les broches D3-D6, C3-C6 et R3-R6 aux appareils des quatre éléments du socle aval S1.

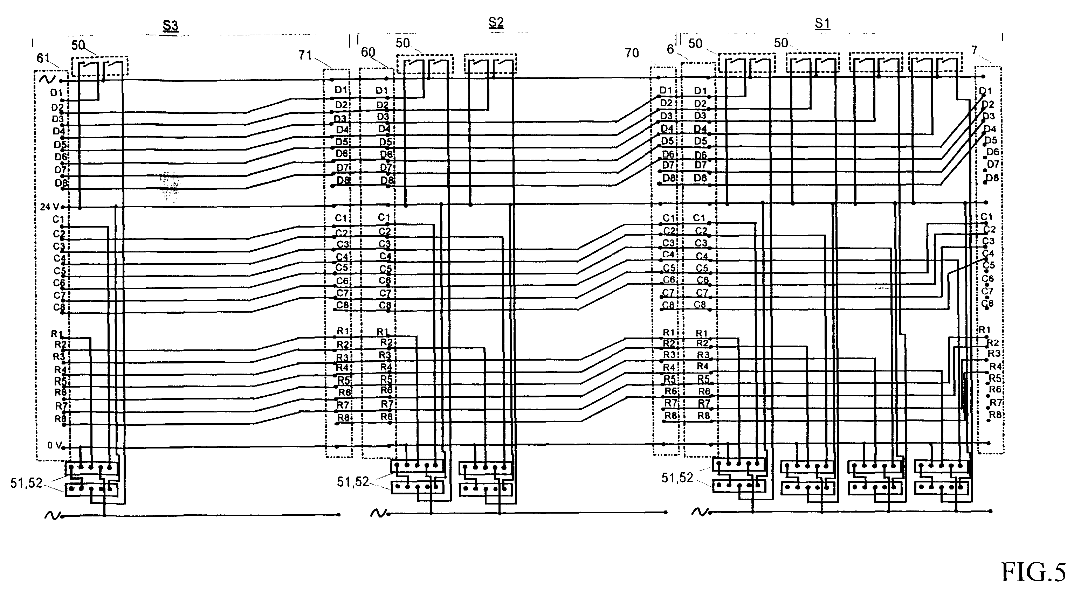

Prenons un autre exemple illustré en figure 5. Il s'agit de l'association d'amont en aval de trois socles S3,S2,S1 qui respectivement comprennent un, deux et quatre éléments de départ.

Les appareils de l'élément du socle S3 sont connectés aux premières broches D1, Ci et Ri du connecteur amont 61. Les broches utilisables D2-D8, C2-C8 et R2-R8 du connecteur amont sont reliées aux premières broches D1-D7, C1-C7 et R1-R7 du connecteur aval 71. Le connecteur amont 61 constitue le connecteur assurant la liaison avec l'automate.

Les appareils de chacun des deux éléments du socle S2 sont respectivement connectés aux premières broches D1-D2, C1-C2 et R1-R2 du connecteur amont 60. Les broches utilisables D3-D8, C3-C8 et R3-R8 du connecteur amont 60 sont reliées aux premières broches D1 -D6, C1-C6 et R1-R6 du connecteur aval 70.

Les appareils de chacun des quatre éléments du socle Si sont respectivement connectés aux premières broches D1-D4, C1-C4 et R1-R4 du connecteur amont 6. Les broches utilisables D5-D8, C5-C8 et R5-R8 du connecteur amont sont reliées aux premières broches D1 -D4, C1 -C4 et R1-R4 du connecteur aval 7.

Un premier conducteur raccordant le connecteur amont 6 du socle Si au connecteur aval 70 du socle S2 permet de relier les broches D1-D4, C1-C4 et R1-R4 du connecteur 6 aux broches D3-D6, C3-C6 et R3-R6 du connecteur amont 60 du socle S2.

Un second conducteur raccordant le connecteur amont 60 du socle S2 au connecteur aval 71 du socle S3 permet de relier les broches utilisées D1-D6, C1-C6, R1-R6 du connecteur amont 60 aux broches D2-D7, C2-C7 et R2-R7 du connecteur amont 61 du socle S3.

Ainsi, les sept éléments de l'ensemble sont raccordés aux broches de connexion D1-D7, C1-C7 et R1-R7 du connecteur amont 61 de l'ensemble, ledit connecteur étant relié à l'automate.

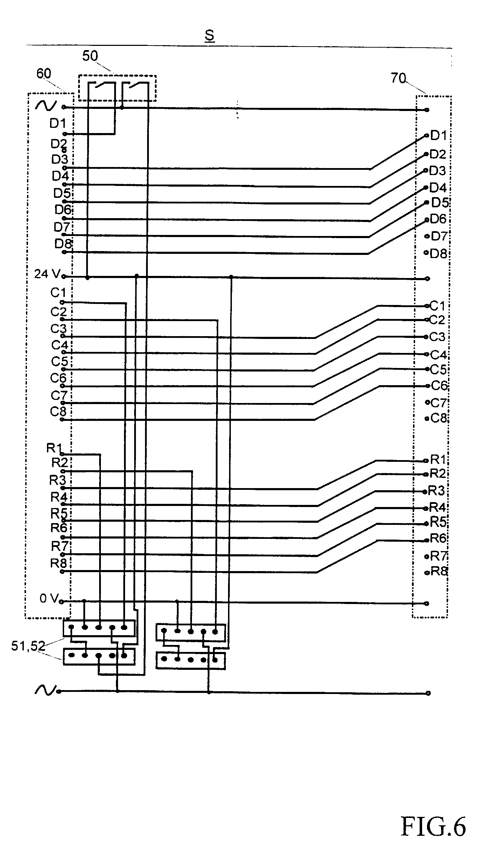

La figure 6 illustre un cas particulier. Il s'agit d'un socle S comprenant un seul ensemble de départ-moteur constitué par un disjoncteur, un relais et un contacteur-inverseur. Le contacteur-inverseur permet d'arrêter et de mettre en marche le moteur dans un sens de rotation ou dans l'autre. Il est en fait constitué par deux contacteurs qui sont couplés électriquement, l'un des deux étant neutralisé selon le sens de rotation désiré. Les lignes d'alimentation n'étant connectées qu'à un seul contacteur, un seul disjoncteur est suffisant pour couper les lignes en cas d'anomalie.

Le disjoncteur 1 est relié à la borne de connexion d'entrée D1 du connecteur amont. En raison de la présence de deux contacteurs pour un seul disjoncteur, il est nécessaire de ne faire aucune connexion sur la broche D2. Les broches utilisables sont par conséquent les broches D3-D8 qui sont reliées aux broches D1-D6 du connecteur aval.

Les deux contacteurs 3 sont reliés aux bornes de connexion d'entrée C1 et C2, les broches utilisables C3-C8 étant raccordées aux broches C1-C6 du connecteur aval.

Les deux relais 40 de commande des bobines de contacteurs sont reliés aux broches de connexion de sortie R1 et R2 du connecteur amont, les broches utilisables R3-R8 étant raccordées aux broches R1-R6 du connecteur aval.

## Revendications

1. Ensemble de départ-moteur comprenant des éléments de départ assemblés côte à côte sur au moins un socle (S) de support, chaque élément comportant des appareils interrupteurs constitués par un disjoncteur (1), un contacteur (3) et un organe interrupteur de commande (40) de la bobine du contacteur, le socle (S) logeant un circuit imprimé (5) muni de pistes conductrices (53a, 53b) et d'un connecteur amont (6) doté de groupes de broches de connexion (D1-D8, C1-C8, R1-R8) auxquelles sont reliés, via les premières pistes conductrices (53a), les appareils interrupteurs (1, 3, 40), et qui sont destinées à être raccordées à un ou plusieurs conducteurs (N) d'un système de contrôle et de commande de l'ensemble, caractérisé en ce que,
- le connecteur amont (6) comprend des broches utilisées pour les appareils du socle (S) et des broches utilisables pour les appareils d'au moins un socle (S) voisin,
- les appareils interrupteurs (1, 3, 40) des divers éléments de départ d'un socle (S) sont raccordés à des broches de connexion du connecteur amont (6) selon un ordre des broches correspondant à celui des emplacements des éléments sur le socle ;
- le circuit imprimé (C) comporte un connecteur aval (7) à groupes de broches de connexion identiques à ceux du connecteur amont (6), les broches utilisables du connecteur amont (6) étant reliées, via des secondes pistes conductrices (53b), en nombre égal et dans l'ordre, aux premières broches de connexion du connecteur aval (7).

2. Ensemble de départ-moteur selon la revendication 1, comprenant plusieurs socles et caractérisé en ce que le conducteur amont (6) d'un socle aval est raccordé au connecteur aval (7) d'un socle amont de manière que leurs broches de connexion soient connectées entre elles dans le même ordre numérique.

3. Ensemble de départ-moteur selon la revendication 1, comprenant plusieurs socles et caractérisé en ce que chaque socle (S) comprend au plus quatre éléments de départ et que l'ensemble de départ-moteur comprend au plus huit éléments de départ.

4. Ensemble de départ-moteur selon la revendication 1, comprenant un socle (S) servant de support à un élément de départ constitué par un disjoncteur (1), deux contacteurs (3) couplés électriquement réalisant la fonction d'inverseur et deux organes interrupteurs (40) associés aux bobines des contacteurs et caractérisé en ce que le disjoncteur (1) est raccordé à la première broche (D1) d'un groupe du connecteur amont, la deuxième broche (D2) de ce groupe n'étant pas destinée à être reliée et les broches restantes (D3-D8) de ce groupe étant des broches utilisables pour le raccordement à d'autres disjoncteurs d'au moins un socle voisin.
